# EUROPÄISCHE PATENTSCHRIFT

(11) **EP 1 488 467 B1**
(45) Veröffentlichungstag und Bekanntmachung des Hinweises auf die Patenterteilung: **08.11.2006**
(21) Anmeldenummer: 03704285.0
(22) Anmeldetag: 04.02.2003
(51) Int. Cl.: H01L 41/22, H01L 41/083

(54) **PIEZOSTACK UND VERFAHREN ZUR HERSTELLUNG EINES PIEZOSTACKS**
PIEZOSTACK AND METHOD FOR PRODUCING A PIEZOSTACK
EMPILEMENT PIEZO-ELECTRIQUE ET PROCEDE POUR PRODUIRE UN EMPILEMENT PIEZO-ELECTRIQUE

(30) Priorität: 21.02.2002 DE 10207292
(43) Veröffentlichungstag der Anmeldung: 22.12.2004
(73) Patentinhaber: SIEMENS AKTIENGESELLSCHAFT, 80333 München (DE)
(72) Erfinder: SCHÜRZ, Willibald, 93188 Pielenhofen (DE)
(86) Internationale Anmeldenummer: PCT/DE2003/000305
(87) Internationale Veröffentlichungsnummer: WO 2003/073524

(56) Entgegenhaltungen:
- DE-A- 10 042 893
- DE-A- 19 951 118

## Beschreibung

Die Erfindung betrifft einen Piezostack und ein Verfahren zur Herstellung eines Piezostacks, wie er beispielsweise für Aktoren zum Antrieb von Kraftstoffinjektoren im Motoren- und Kraftfahrzeugbau verwendet werden kann.

Bisher bekannte Vielschicht-Piezoaktoren werden in einem Fertigungsverfahren hergestellt, welches im Wesentlichen die folgenden Prozessschritte aufweist. In einem ersten Schritt wird eine Folie hergestellt, die in einem zweiten Schritt bedruckt, in einem dritten Schritt gestapelt und in einem vierten Schritt zu einer Scheibe oder einem Block mit einer Abmessung von beispielsweise 10 x 10 cm gepresst wird. In einem fünften Schritt erfolgt die Trennung, der Scheibe in mehrere beispielsweise 5 mm breite Piezostacks. Die Trennung kann zum Beispiel durch Sägen erfolgen. Anschließend werden in einem sechsten Schritt die Piezostacks entbindert. Das heißt, das Bindemittel in Form von Kunstharz, mit dem das Keramikpulver gemischt und zu Folien verarbeitet wurde, wird wieder ausgetrieben. In einem siebten Schritt werden die Piezostacks gesintert und in einem achten Schritt geschliffen. In einem neunten Schritt werden die Piezostacks metallisiert, das heißt mit einem Außenleiter für die elektrische Kontaktierung versehen, in einem zehnten Schritt erfolgt die Einbrennung, in einem elften Schritt das Löten der Außenkontaktierung, in einem zwölften Schritt das Vergießen, in einem dreizehnten Schritt der Einbau in ein Gehäuse und in einem vierzehnten Schritt das elektrische Polen.

Die Außenelektroden, in der Regel sind dies zwei, erstrecken sich über die Längsseite des Piezostacks und liegen zueinander diagonal gegenüber. Um zu verhindern, dass jede Innenelektrode mit jeder Außenelektrode elektrisch in Verbindung kommt, sind auf jeder Schicht des Piezostacks ebenfalls zueinander diagonal gegenüberliegende elektrisch inaktive Zonen vorhanden.

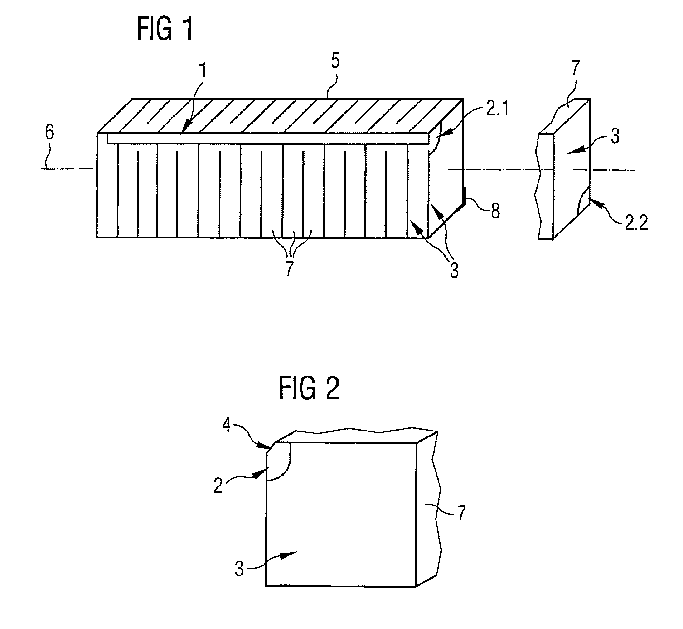

Ein entsprechender prinzipieller Aufbau eines Vielschicht-Keramikaktors ist in Figur 1 gezeigt. Die einzelnen Keramikschichten 7 sind durch metallische Innenelektroden 3, deren Schichtstärke wenige µm beträgt, voneinander getrennt. Durch die elektrisch inaktiven Zonen 2.1 und 2.2 der Innenelektroden 3, welche in dieser Ausführungsform zueinander diagonal gegenüberliegend im äußeren Bereich des Piezostacks 5 angeordnet sind, ist es möglich, über eine Außenmetallisierung 1 im Bereich der inaktiven Zonen 2, die Innenelektroden 3 abwechslungsweise auf unterschiedliches elektrisches Potential zu legen. Die dabei in den Piezoaktor eingebrachten elektrischen Ladungen bewirken die Längenänderung des Piezoaktors.

Um eine reine Längenänderung des Piezoaktors ohne Verkrümmung entlang der Längsachse 6 zu erreichen, ist es erforderlich, dass die elektrisch inaktiven Zonen 2 nur innerhalb sehr enger Toleranzen in ihrer Größe und Lage unterschiedlich sein dürfen. Die Verkrümmung des Piezostacks 5 ist insbesondere dann ausgeprägt, wenn sich die elektrisch inaktiven Zonen 2 einer Seite in ihrer Größe deutlich von den elektrisch inaktiven Zonen der gegenüberliegenden Seite unterscheiden.

Ein derartiger Piezoaktor ist aus DE 100 42 893 bekannt.

Um die Verkrümmung des Piezostacks 5 unterhalb einer zulässigen Grenze zu halten, sind die Toleranzanforderungen an die Größe und die Lage der elektrisch inaktiven Zonen derart hoch, dass diese bisher durch ein kostengünstiges Fertigungsverfahren nicht prozesssicher erreicht werden können.

Eine Möglichkeit den Nachteil der Verkrümmung des Piezostacks während einer Längenänderung zu vermeiden, besteht darin, die Verkrümmung zu kompensieren. Dies geschieht, indem der Piezostack auf eine Membran gestellt wird, welche sich radial am Piezoaktorgehäuse abstützt. Mit einer derartigen Führung wird ein seitliches Auslenken vermieden. Diese Ausführungsform beseitigt jedoch die Verkrümmung des Piezostacks nicht und hat zudem den Nachteil, dass sie durch die Membran mehr Bauraum in Anspruch nimmt.

Es ist daher eine Aufgabe der Erfindung, ein Verfahren zur Herstellung eines Piezostacks anzugeben, bei dem der nach diesem Verfahren hergestellte Piezostack bei einer Längenänderung eine geringere Verkrümmung aufweist als dies bisher der Fall ist.

Das erfindungsgemäße Verfahren zur Herstellung eines Piezostacks hat zudem den Vorteil, dass der nach diesem Verfahren hergestellte Piezostack mit einem geringeren Bauraum auskommt als die zuvor beschriebene Ausführungsform.

Die Aufgabe wird durch ein Verfahren zur Herstellung eines Piezostacks mit den im Patentanspruch 1 angegebenen Merkmalen und durch einen Piezostack mit den im Patentanspruch 12 angegebenen Merkmalen gelöst.

Das erfindungsgemäße Verfahren zur Herstellung eines Piezostacks weist folgende Schritte auf. Bei einem Piezostack mit auf mehreren Seiten des Piezostacks angeordneten elektrisch inaktiven Zonen, wird zuerst die Unsymmetrie der elektrisch inaktiven Zonen bestimmt. Anschließend werden die elektrisch inaktiven Zonen mit Übergröße so lange verkleinert, bis die Unsymmetrie ein zulässiges Maß erreicht.

Der erfindungsgemäße Piezostack weist auf mehreren Seiten elektrisch inaktive Zonen auf. Zur Vereinheitlichung der Größen der elektrisch inaktiven Zonen, ist eine Fase entlang des Piezostacks im Bereich der elektrisch inaktiven Zonen mit Übergröße vorgesehen.

Vorteilhafte Weiterbildungen des erfindungsgemäßen Verfahrens zur Herstellung eines Piezostacks und des erfindungsgemäßen Piezostacks ergeben sich aus den in den abhängigen Patentansprüchen angegebenen Merkmalen.

Bei der Weiterbildung gemäß Patentanspruch 2 werden zur Bestimmung der Unsymmetrie der elektrisch inaktiven Zonen die inaktiven Zonen vermessen.

Vorteilhafter Weise sind Maße, die zur Bestimmung der Unsymmetrie herangezogen werden, die Breiten der elektrisch inaktiven Zonen.

Bei einer weiteren Ausführungsform erfolgt die Vermessung durch ein optisches Messverfahren.

Es ist von Vorteil, wenn bei dem optischen Messverfahren eine digitale Bildverarbeitung angewendet wird. Dadurch kann schnell, einfach, sicher und mit gleichbleibender Qualität die Unsymmetrie der elektrisch inaktiven Zonen bestimmt werden.

Die Verkleinerung der inaktiven Zonen kann dadurch erfolgen, dass sie angeschliffen werden.

Bei einer weiteren Ausführungsform der Erfindung wird die Kante des Piezostacks, bei der sich die elektrisch inaktiven Zonen des Piezostacks befinden, angeschliffen.

Bei einer weiteren Ausführungsform der Erfindung wird durch das Verkleinern der elektrisch inaktiven Zonen eine Fase erzeugt.

Vorteilhafter Weise ist der Fasenwinkel einstellbar. Dadurch kann sowohl die eine als auch die andere Seite der elektrisch inaktiven Zonen, welche die Übergröße aufweisen, auf die Maße der gegenüberliegenden inaktiven Zonen angepasst werden.

Zudem ist es von Vorteil, wenn über die Länge der Kante des Piezostacks die Fase mit einem bestimmten Profil erzeugt werden kann. Eine über die Länge des Piezostacks ungleichmäßig verteilte Unsymmetrie der elektrisch inaktiven Zonen kann dadurch beseitigt werden.

In einer Weiterbildung wird auf dem Piezostack eine Außenmetallisierung aufgebracht, um die elektrisch aktiven Zonen miteinander zu verbinden.

Schließlich weist bei einer vorteilhaften Ausführungsform des erfindungsgemäßen Piezoaktors die Fase des Piezoaktors über die Länge des Piezostacks ein von der Übergröße der elektrisch inaktiven Zonen abhängiges Profil auf. Damit wird erreicht, dass eine sich über die Länge des Piezostacks verändernde Unsymmetrie der elektrisch inaktiven Zonen ausgeglichen werden kann.

Im Folgenden wird die Erfindung anhand von zwei Figuren weiter erläutert.
- Figur 1: zeigt den prinzipiellen Aufbau eines Piezostacks in einer dreidimensionale Ansicht.
- Figur 2: zeigt eine Schicht des Piezostacks in der Draufsicht.

Der Piezostack 5 in seiner Ausgangsform, wie er in Figur 1 prinzipiell gezeigt ist, ist grundsätzlich, wie in den Schritten eins bis vierzehn in der Beschreibungseinleitung beschrieben, hergestellt und aufgebaut. Der Piezostack 5 weist eine Vielzahl von Keramikschichten 7 auf, die beidseitig mit einer elektrisch aktiven Zone, im Folgenden auch als Innenelektrode 3 bezeichnet, versehen sind. Zusätzlich weisen die Keramikschichten 7 auch elektrisch inaktive Zonen 2 auf. In der Figur 1 ist eine elektrisch inaktive Zone 2.1 einer n-ten Keramikschicht und eine elektrisch inaktive Zone 2.2 einer n+1-ten Keramikschicht gezeigt. An den Kanten des Piezostacks 5, an denen die elektrisch inaktiven Zonen 2, 2.1, 2.2 angeordnet sind, befindet sich eine Außenmetallisierung 1 oder Außenleiter, welche dazu dient, die elektrisch aktiven Zonen 3 elektrisch miteinander zu verbinden. Die elektrisch inaktiven Zonen 2, 2.1, 2.2 dienen, wie bereits eingangs erwähnt, dazu, dass nicht alle elektrisch aktiven Zonen 3 miteinander über den Außenleiter 1 elektrisch verbunden sind. Die zwei angeordneten Außenmetallisierungen 1, 8 sind an gegenüber liegenden Eckbereichen des Piezostacks 5 angebracht. Die aktiven Zonen 3 sind abwechselnd mit einer der zwei Außenmetallisierungen 1, 8 verbunden. Durch das Anlegen unterschiedlicher Spannungen an die zwei Außenmetallisierungen 1, 8 wird ein elektrisches Feld an eine Keramikschicht 7 angelegt, die von zwei Zonen 3 begrenzt ist. Abhängig vom elektrischen Feld dehnt sich die Keramikschicht 7 aus oder zieht sich zusammen. In entsprechender Weise verhalten sich alle Keramikschichten 7, so dass es zu einer Verlängerung oder Verkürzung des Piezostack 5 kommt. In Figur 1 ist dies exemplarisch gezeigt. Nur jeweils jede zweite elektrisch aktive Zone 3 einer Seite des Piezostacks ist mit dem gleichen Außenleiter 1, 8 verbunden.

Beim Zertrennen oder Zersägen der Vielschicht-Keramikscheibe in mehrere Piezostacks und Schleifen der Piezostacks auf ihre Sollmaße, entsteht in der Regel, bedingt durch Fertigungstoleranzen, eine Unsymmetrie bezüglich der elektrisch inaktiven Zonen 2.1, 2.2. Das heißt, die eine oder die andere Kante, an der die elektrisch inaktiven Zonen 2.1, 2.2 angeordnet sind, weist unterschiedlich große elektrisch inaktive Zonen 2.1, 2.2 auf. Um diese Unsymmetrie zu beseitigen, wird die Kante, an der sich die größeren elektrisch inaktiven Zonen 2.1, 2.2 befinden, mit einer Fase 4 versehen, so dass die Länge und Breite der elektrisch inaktiven Zonen 2.1, 2.2 verkleinert wird. Das Ergebnis dieser Bearbeitung ist in Figur 2 gezeigt.

Wird beim Zersägen nicht exakt rechtwinklig gearbeitet, so entsteht über die Länge des Piezostacks 5 eine unterschiedliche Verteilung der Unsymmetrie. Es kann sein, dass am einen Ende des Piezostacks 5 keine und am anderen Ende eine erhebliche Unsymmetrie vorliegt. Dem kann beim Schleifen der Kante entgegnet werden, indem die durch das Schleifen der Kante entstehende Fase 4 ein über die Länge des Piezostacks 5 verändertes Profil erhält. Das bedeutet, dass auf der Seite, auf der kein Fehler vorhanden ist, keine Fase 4 angebracht wird und zu der Seite hin, auf der die Unsymmetrie erheblich ist, die Fase 4 zunimmt.

Der Fasenwinkel kann so gewählt werden, dass die Unsymmetrie weiter reduziert wird.

Es ist auch möglich an beiden zueinander diagonal gegenüberliegenden Kanten des Piezostacks, an denen die elektrisch inaktiven Zonen 2.1, 2.2 angeordnet sind, jeweils eine Fase 4 derart anzubringen, dass die elektrisch inaktiven Zonen 2, 2.1, 2.2 gleiche Abmaße erhalten.

Im Hinblick auf die Fertigungskosten erscheint es jedoch günstiger, lediglich eine Fase 4 am Piezostack 5 anzubringen, da damit ein zusätzlicher Schleifvorgang entfällt.

Die Vermessung der elektrisch inaktiven Zonen erfolgt durch ein optisches Verfahren und eine digitale Bildverarbeitung. Die Unsymmetrie wird aus den gewonnenen Messwerten errechnet. Dazu werden mittels einer Kamera die Außenflächen des Piezostacks 5 aufgenommen und die Bilder einer digitalen Bildverarbeitungseinheit zugeführt. Da auf den von der Kamera gelieferten Bildern die Länge und die Lage der Innenelektroden 3 des Piezostacks 5 erkennbar sind, kann anhand dieser Werte ausgewertet werden, auf welcher Seite des Piezostacks 5 die größeren elektrisch inaktiven Zonen vorhanden sind. Eine Kameraaufnahme des Piezostacks 5 im Querschnitt ist somit nicht erforderlich. Für eine ausreichend genaue Bestimmung der Unsymmetrie genügt die Kenntnis über die äußerlich am Piezostack 5 erkennbaren Dimensionen, vorzugsweise der Breite, der elektrisch inaktiven Zonen 2, 2.1, 2.2 oder der elektrisch aktiven Zonen 3. Von den Dimensionen der elektrisch aktiven Zonen 3 kann auch auf die Dimensionen der elektrisch inaktiven Zonen 2, 2.1, 2.2 geschlossen werden.

Nachdem die Unsymmetrie beseitigt wurde, wird die Außenmetallisierungen 1, 8 auf den Piezostack 5 aufgebracht.

Die Anordnung der Außenleiter 1, 8 der elektrisch inaktiven Zonen 2, 2.1, 2.2 sowie der elektrisch aktiven Zonen 3 ist in den Figuren nur beispielhaft gezeigt. Je nach Anwendungsfall können die Außenleiter 1, 8, die elektrisch inaktiven Zonen 2, 2.1, 2.2 sowie die elektrisch aktiven Zonen 3 ohne weiteres auch anders angeordnet werden. Dadurch wird der Rahmen der Erfindung nicht verlassen.

## Patentansprüche

1. Verfahren zur Herstellung eines Piezostacks,
das folgende Schritte aufweist:
bei einem Piezostack (5) mit auf mehreren Seiten des Piezostacks (5) angeordneten elektrisch inaktiven Zonen (2, 2.1, 2.2) wird die Unsymmetrie der elektrisch inaktiven Zonen (2, 2.1, 2.2) bestimmt,
die elektrisch inaktive Zone (2, 2.1, 2.2) mit Übergröße wird auf ein zulässiges Maß der Unsymmetrie verkleinert.

2. Verfahren nach Patentanspruch 1,
bei dem zur Bestimmung der Unsymmetrie der elektrisch inaktiven Zonen (2, 2.1, 2.2) die elektrisch inaktiven Zonen (2, 2.1, 2.2) vermessen werden.

3. Verfahren nach Patentanspruch 2,
bei dem zur Bestimmung der Unsymmetrie die Breiten der elektrisch inaktiven Zonen (2, 2.1, 2.2) sind herangezogen werden.

4. Verfahren nach einem der Patentansprüche 1 bis 3,
bei dem die Vermessung durch ein optisches Messverfahren erfolgt.

5. Verfahren nach Patentanspruch 4,
bei dem beim optischen Messverfahren eine digitale Bildverarbeitung angewendet wird.

6. Verfahren nach einem der Patentansprüche 1 bis 5,
bei dem die Verkleinerung der elektrisch inaktiven Zonen (2, 2.1, 2.2) **dadurch** erfolgt, dass die elektrisch inaktiven Zonen (2, 2.1, 2.2) angeschliffen werden.

7. Verfahren nach Patentanspruch 6,
bei dem die Kante des Piezostacks (5) bei der sich die elektrisch inaktiven Zonen (2, 2.1, 2.2) des Piezostacks (5) befinden, angeschliffen wird.

8. Verfahren nach einem der Patentansprüche 1 bis 7,
bei dem durch das Verkleinern der elektrisch inaktiven Zonen (2, 2.1, 2.2) eine Fase (4) erzeugt wird.

9. Verfahren nach Patentanspruch 8,
bei dem der Fasenwinkel einstellbar ist.

10. Verfahren nach Patentanspruch 7, 8 oder 9,
bei dem über die Länge der Kante des Piezostacks (5) die Fase (4) mit einem bestimmten Profil erzeugt wird.

11. Verfahren nach einem der Patentansprüche 1 bis 10,
bei dem auf dem Piezostack (5) Außenmetallisierungen (1, 8) aufgebracht werden, um abwechselnd die aufeinander folgenden elektrisch aktiven Zonen (3) miteinander zu verbinden.

12. Piezostack (5),
bei dem auf mehreren Seiten elektrisch inaktive Zonen (2, 2.1, 2.2) vorhanden sind,
bei dem zur Vereinheitlichung der Größen der elektrisch inaktiven Zonen (2, 2.1, 2.2) eine Fase (4) entlang einer Seite des Piezostacks (5) im Bereich der elektrisch inaktiven Zonen (2, 2.1, 2.2) angebracht ist.

13. Piezostack nach Anspruch 12, **dadurch gekennzeichnet, dass** die Fase (4) über die Länge des Piezostacks (5) ein von der Übergröße der elektrisch inaktiven Zonen (2, 2.1, 2.2) abhängiges Profil aufweist.

## Claims

1. Method for producing a piezostack,
having the following steps:
determining, for a piezostack (5) with electrically inactive zones (2, 2.1, 2.2) arranged on multiple sides of the piezostack (5), the asymmetry of the electrically inactive zones (2, 2.1, 2.2),
reducing the electrically inactive zone (2, 2.1, 2.2) with oversize to a permissible degree of asymmetry.

2. Method according to Claim 1,
in which to determine the asymmetry of the electrically inactive zones (2, 2.1, 2.2) the electrically inactive zones (2, 2.1, 2.2) are measured.

3. Method according to Claim 2,
in which to determine the asymmetry the widths of the electrically inactive zones (2, 2.1, 2.2) are taken into account.

4. Method according to one of Claims 1 to 3,
in which the measurement is carried out by means of an optical measuring procedure.

5. Method according to Claim 4,
in which digital image processing is employed for the optical measuring procedure.

6. Method according to one of Claims 1 to 5,
in which the reduction of the electrically inactive zones (2, 2.1, 2.2) is effected by grinding the electrically inactive zones (2, 2.1, 2.2).

7. Method according to Claim 6,
in which the edge of the piezostack (5) on which the electrically inactive zones (2, 2.1, 2.2) of the piezostack (5) are located is ground off.

8. Method according to one of Claims 1 to 7,
in which a chamfer (4) is created by reducing the electrically inactive zones (2, 2.1, 2.2).

9. Method according to Claim 8,
in which the angle of the chamfer is adjustable.

10. Method according to Claim 7, 8 or 9,
in which the chamfer (4) is created with a specific profile over the length of the edge of the piezostack (5).

11. Method according to one of Claims 1 to 10,
in which external metallisations (1, 8) are applied to the piezostack (5) in order alternately to connect the consecutive electrically active zones (3) to each other.

12. Piezostack (5),
in which electrically inactive zones (2, 2.1, 2.2) are present on multiple sides,
in which in order to standardise the sizes of the electrically inactive zones (2, 2.1, 2.2) a chamfer (4) is applied along one side of the piezostack (5) in the region of the electrically inactive zones (2, 2.1, 2.2).

13. Piezostack according to Claim 12, **characterised in that** the chamfer (4) over the length of the piezostack (5) has a profile which is dependent on the oversize of the electrically inactive zones (2, 2.1, 2.2).

## Revendications

1. Procédé de réalisation de piles piézoélectriques, comportant les étapes suivantes :
dans une pile piézoélectrique (5) avec des zones électriquement inactives (2, 2.1, 2.2), disposées sur plusieurs côtés de la pile piézoélectrique (5), on détermine la dissymétrie des zones électriquement inactives (2, 2.1, 2.2),
la zone électriquement inactive (2, 2.1, 2.2) présentant une surdimension est diminuée à une valeur admissible de la dissymétrie.

2. Procédé selon la revendication 1, dans lequel, pour déterminer la dissymétrie des zones électriquement inactives (2, 2.1, 2.2), on mesure les zones électriquement inactives (2, 2.1, 2.2).

3. Procédé selon la revendication 2, dans lequel, pour déterminer la dissymétrie, on tient compte de la largeur des zones électriquement inactives (2, 2.1, 2.2).

4. Procédé selon l'une quelconque des revendications 1 à 3, dans lequel la mesure est effectuée au moyen d'un procédé de mesure optique.

5. Procédé selon la revendication 4, dans lequel un traitement d'image numérique est appliqué dans le procédé de mesure optique.

6. Procédé selon l'une quelconque des revendications 1 à 5, dans lequel la diminution des zones électriquement inactives (2, 2.1, 2.2) est effectuée par le fait que les zones électriquement inactives (2, 2.1, 2.2) sont affûtées.

7. Procédé selon la revendication 6, dans lequel on affûte l'arête de la pile piézoélectrique (5), au niveau de laquelle se situent les zones électriquement inactives (2, 2.1, 2.2) de la pile piézoélectrique (5).

8. Procédé selon l'une quelconque des revendications 1 à 7, dans lequel un chanfrein (4) est réalisé par la diminution des zones électriquement inactives (2, 2.1, 2.2).

9. Procédé selon la revendication 8, dans lequel l'angle du chanfrein est réglable.

10. Procédé selon la revendication 7, 8 ou 9, dans lequel le chanfrein (4) est réalisé avec un profil déterminé sur la longueur de l'arête de la pile piézoélectrique (5).

11. Procédé selon l'une quelconque des revendications 1 à 10, dans lequel des métallisations extérieures (1, 8) sont déposées sur la pile piézoélectrique (5) afin de relier entre elles de manière alternée les zones électriquement actives (3) successives.

12. Pile piézoélectrique (5)
dans laquelle des zones électriquement inactives (2, 2.1, 2.2) sont présentes sur plusieurs côtés,
dans laquelle un chanfrein (4) est réalisé le long d'un côté de la pile piézoélectrique (5) dans la partie des zones électriquement inactives (2, 2.1, 2.2) pour homogénéiser les dimensions des zones électriquement inactives (2, 2.1, 2.2).

13. Pile piézoélectrique (5) selon la revendication 12, **caractérisée en ce que** le chanfrein (4) comporte sur la longueur de la pile piézoélectrique (5) un profil qui dépend de la surdimension des zones électriquement inactives (2, 2.1, 2.2).
